# DEMANDE DE BREVET EUROPEEN

(11) **EP 3 496 101 A1**
(43) Date de publication de la demande: **12.06.2019**
(21) Numéro de dépôt: 18210618.7
(22) Date de dépôt: 06.12.2018
(51) Int. Cl.: G11C 7/24, G11C 11/419, G11C 7/20, G11C 7/12, G11C 11/417, G11C 11/418, G11C 8/10

(54) **MEMOIRE SRAM A EFFACEMENT RAPIDE**

(30) Priorité: 06.12.2017 FR 1761692
(71) Demandeur: Commissariat à l'énergie atomique et aux énergies alternatives, 75015 Paris (FR)
(72) Inventeur: NOEL, Jean-Philippe, 38000 GRENOBLE (FR); BOHER, Noémie, 2612 RS DELFT (NL); WACQUEZ, Romain, 13005 MARSEILLE (FR)
(74) Mandataire: Brevalex

(57) **Abrégé**

Dispositif de mémoire statique à accès aléatoire comprenant une matrice mémoire dotée d'au moins une colonne (COL₁) formée d'une pluralité de cellules (C₁₁, C_{N1}) mémoires SRAM, le dispositif étant doté d'un circuit d'effacement rapide de la mémoire configuré pour consécutivement à une réception d'un signal d'effacement (ERASE), connecter entre elles une première ligne de bit (BL_{T}) et une deuxième ligne de bit (BL_{F}) partagée par les cellules de ladite colonne.

## Description

### DOMAINE TECHNIQUE ET ART ANTÉRIEUR

La présente invention se rapporte au domaine des mémoires de type SRAM (SRAM pour « Static Random Access Memory » ou mémoire vive statique à accès aléatoire), et concerne en particulier celui de la mise en oeuvre de contre-mesures pour empêcher un accès non-autorisé à des informations stockées dans une matrice de cellules mémoires SRAM.

La présente invention met en oeuvre un circuit d'effacement rapide de données mémorisées dans une mémoire SRAM.

### ART ANTÉRIEUR

Une mémoire SRAM a pour fonction le stockage d'informations volatiles dont certaines peuvent être confidentielles et/ou sécurisées. Pour permettre de protéger certaines données contenues dans un dispositif mémoire, par exemple une clé d'encryptage, et empêcher leur accès à un tiers non-autorisé, une mesure classique consiste, lorsqu'on a détecté une tentative d'accès frauduleux, à effacer le contenu de ces informations qui sont mémorisées par les cellules mémoires.

Une méthode d'effacement de mémoire volatile consiste simplement à couper l'alimentation de la mémoire volatile lorsqu'un accès ou une tentative d'accès non-autorisé(e) est détecté(e).

La durée d'effacement est dans ce cas directement liée à la capacité électrique des lignes d'alimentation du plan mémoire qui sont typiquement agencées sous forme d'une grille d'alimentation. Or la capacité électrique d'une telle grille d'alimentation peut aller jusqu'à plusieurs dizaines de pF et le temps de décharge peut être par conséquent de l'ordre de la microseconde, voire de la milliseconde suivant les conditions de température.

Pour pallier un problème de lenteur d'effacement de la mémoire, une solution consiste à prévoir des dispositifs à base de diodes pour l'évacuation rapide des charges. Néanmoins, ce type de dispositif d'effacement, bien qu'efficace, est pénalisant en terme de surcoût en surface.

Le document US 8°885°429°B1 concerne une mémoire SRAM dotée d'un circuit d'effacement de la mémoire configuré pour conduire une opération d'écriture forcée en imposant une valeur logique donnée à un ensemble de cellules.

Une telle opération d'effacement a notamment pour inconvénient qu'elle nécessite un budget énergétique important et qu'elle peut s'avérer relativement lente à mettre en oeuvre.

La présente demande vise à trouver un nouveau type de circuit d'effacement des données contenues dans une SRAM qui soit amélioré vis-à-vis d'inconvénients mentionnés ci-dessus.

### EXPOSÉ DE L'INVENTION

La présente invention vise à mettre en place une contre mesure à un accès non autorisé qui permet d'effacer rapidement, de manière intégrale et irréversible, le contenu des cellules SRAM d'une matrice de cellules SRAM.

Pour cela, un mode de réalisation de la présente invention prévoit un dispositif de mémoire statique à accès aléatoire comprenant une matrice mémoire dotée d'au moins une colonne formée d'une pluralité de cellules mémoires SRAM chacune desdites cellules comprenant :
- un premier noeud de stockage d'information logique et un deuxième noeud de stockage d'information logique complémentaire,
- un premier transistors d'accès au premier noeud de stockage et un deuxième transistor d'accès au deuxième noeud de stockage, le premier transistor d'accès et le deuxième transistor d'accès étant respectivement connectés à une première ligne de bit et à une deuxième ligne, la première ligne de bit et la deuxième ligne de bit étant partagée par lesdites cellules de ladite colonne,

le dispositif étant doté en outre d'un circuit d'effacement de la mémoire configuré pour consécutivement à une réception d'un signal d'effacement, rendre passant les transistor d'accès desdites cellules connectées à la première ligne de bit et la deuxième ligne de bit et connecter entre elles ladite première ligne de bit et ladite deuxième ligne de bit.

Le mécanisme d'effacement mis en oeuvre permet l'évacuation des charges électriques contenues dans chacune des cellules élémentaires de mémorisation indépendamment du mode (lecture, écriture, rétention) dans laquelle le circuit mémoire se situe. Les noeuds des cellules effacées sont mis à un potentiel intermédiaire qui est intermédiaire entre celui correspondant à un niveau logique '0' et un niveau logique '1'.

Un tel mécanisme rend une remontée aux informations effacées particulièrement difficile, et en particulier plus difficile que lorsque l'on effectue une opération d'effacement en imposant un état logique donné à un ensemble de cellules.

Les cellules mémoires SRAM de la colonne reçoivent un potentiel d'alimentation, par exemple VDD, d'un moyen d'alimentation comprenant une ou plusieurs lignes d'alimentation aptes à être connectées à un circuit d'alimentation de la matrice. De préférence, consécutivement à la réception du signal d'effacement, le circuit d'effacement permet de mettre en haute impédance ou de laisser flottante(s) la ou les lignes d'alimentation qui fournissent ce potentiel d'alimentation aux cellules mémoires de ladite colonne. Cette caractéristique, particulièrement avantageuse, participe à la mise en oeuvre d'une évacuation très rapide des charges électriques tout en limitant la consommation lors du processus d'effacement.

Selon un mode de réalisation, le circuit d'effacement peut être doté d'au moins un premier élément commutateur, telle qu'une première porte de passage, configuré(e) pour alternativement connecter entre elles et déconnecter l'une de l'autre la première ligne de bit et la deuxième ligne de bit, l'élément commutateur étant commandé par le signal d'effacement et étant agencé entre une extrémité de ladite colonne de cellule et une portion d'un circuit périphérique à ladite matrice, ledit circuit périphérique étant doté d'un amplificateur de lecture et/ou d'un pilote d'opérations d'écriture.

Le circuit d'effacement peut être doté en outre d'autres éléments commutateurs, en particulier d'une deuxième porte de passage et d'une troisième porte de passage, commandé(e)s par le signal d'effacement, et configuré(e)s pour, consécutivement à une réception du signal d'effacement, déconnecter respectivement la première ligne de bit et la deuxième ligne de bit de ladite portion de circuit périphérique.

Ainsi, lors du processus d'effacement on isole avantageusement la matrice de cellules d'un circuit périphérique consommateur.

La matrice mémoire peut être alimentée par un circuit d'alimentation apte à délivrer un potentiel d'alimentation VDD à au moins une ligne d'alimentation partagée par une pluralité de cellules données. Avantageusement, ledit circuit d'effacement peut être alors doté en outre d'un élément interrupteur commandé par le signal d'effacement rapide et configuré pour, consécutivement à une réception d'un signal d'effacement, déconnecter ladite ligne d'alimentation dudit circuit d'alimentation.

Ainsi, on déconnecte ou en met en haute impédance ou on laisse flottante la ligne d'alimentation qui connecte toutes les cellules mémoires de la colonne à une alimentation à VDD. Cette ligne d'alimentation peut être également appelée ligne d'alimentation virtuelle puisqu'elle n'est pas directement connecté à l'alimentation VDD mais cette connexion se fait au travers d'un élément interrupteur, tel que par exemple un transistor, en particulier de type PMOS.

Lors du processus d'effacement, la matrice mémoire peut être déconnectée de son alimentation tandis qu'une mise hors tension ou à la masse du circuit d'alimentation n'est pas nécessaire. D'autres éléments périphériques à la matrice peuvent être ainsi maintenus alimentés pendant le processus d'effacement.

Selon un mode de réalisation, ladite pluralité de cellules données connectée à ladite ligne d'alimentation appartient typiquement à la dite colonne de cellules.

La matrice mémoire est typiquement associée à un contrôleur périphérique pour la gestion de processus de lecture et d'écriture. Avantageusement, le circuit d'effacement comprend des moyens ou un au moins un élément de circuit, intégré(s) audit contrôleur périphérique et doté(s) d'un inverseur, les moyens ou l'élément de circuit étant prévu(s) pour appliquer le signal d'effacement et un signal complémentaire dudit signal d'effacement, en particulier à un ou plusieurs éléments commutateurs et/ou interrupteurs du circuit d'effacement.

La matrice est typiquement agencée en outre en rangées d'une ou plusieurs cellules SRAM, une pluralité de lignes de mot étant connectées respectivement à ladite pluralité de cellules mémoires SRAM de la dite colonne, chaque ligne mot permettant lorsqu'elle est activée de sélectionner la ou les cellules mémoires d'une rangée donnée de cellules SRAM parmi lesdites rangées de cellules SRAM.

Selon une possibilité de mise en oeuvre, le circuit d'effacement peut comprendre en outre des moyens d'activation ou une portion de circuit d'activation intégrés à un décodeur de lignes associés à la matrice et configuré pour effectuer une activation simultanée des lignes de mot, de manière à effectuer une sélection simultanée desdites rangées de cellules SRAM.

De préférence, en plus de court-circuiter les lignes de bits, le circuit d'effacement rapide est configuré pour activer toutes les lignes (WL) de la matrice en même temps.

Selon une possibilité de mise en oeuvre du circuit d'effacement, les moyens d'activation de ligne de mots peuvent comporter une pluralité de transistors disposés respectivement à différents étages du décodeur de lignes, lesdits transistors ayant une électrode de grille commandée par le signal d'effacement.

Selon une possibilité de mise en oeuvre, le circuit d'effacement peut comprendre dans le décodeur de lignes, des moyens pour délivrer un signal de cadencement de portes logiques dynamiques du décodeur de lignes, ces moyens pour délivrer le signal de cadencement formant un OU logique entre un signal d'horloge interne du contrôleur et le signal d'effacement ERASE.

Avantageusement, le circuit d'effacement peut être doté d'un étage de détection de fin d'effacement pour produire un signal de fin d'effacement indiquant la fin d'une opération d'effacement réalisée par ledit circuit d'effacement.

Selon une possibilité de mise en oeuvre, l'étage de détection de fin d'effacement peut être configuré de sorte à :- détecter, lorsqu'un courant issu d'une ligne d'alimentation basse reliées auxdites cellules de la matrice, passe en dessous d'un seuil et, consécutivement à ce passage :
- générer le signal de fin d'effacement.

Le circuit d'effacement peut également comprendre un étage de commande d'état du signal d'effacement ERASE pour, consécutivement à une réception dudit signal de fin d'effacement, modifier l'état dudit signal d'effacement ERASE.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1, illustre un exemple de cellule mémoire vive statique suivant l'art antérieur, susceptible d'être intégrée à un dispositif de SRAM dotée d'un circuit d'effacement rapide de données suivant l'invention ;
- la figure 2, illustre un mode de réalisation d'un circuit d'effacement rapide de cellules SRAM suivant l'invention ;
- la figure 3 donne un exemple de chronogramme illustrant les différentes phases d'un processus d'effacement de données stockées dans des cellules SRAM et tel que mis en oeuvre à l'aide d'un circuit d'effacement selon un mode de réalisation de la présente invention ;
- la figure 4 donne un exemple de chronogramme illustrant à titre de comparaison un effacement uniquement par mise à la masse des lignes d'alimentation de la matrice ;
- la figure 5 sert à illustrer un exemple d'étage permettant de produire un signal de détection de fin d'opération d'effacement ;
- la figure 6 sert à illustrer un exemple d'étage de commande d'état d'un signal d'effacement permettant de commander différents éléments participant à l'opération d'effacement rapide ;
- la figure 7 sert à illustrer un exemple de séquencement de signaux d'effacement et de détection de fin d'effacement susceptibles d'être produits dans un circuit d'effacement rapide tel que mis en oeuvre suivant l'invention ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un circuit d'effacement rapide tel que mis en oeuvre suivant l'invention peut être intégré à un dispositif de SRAM comprenant un plan mémoire formé d'au moins une colonne COL₁ de cellules C₁₁,...,C_{N1}. Typiquement, le plan mémoire est doté d'une pluralité de lignes LIN₁,...LIN_{N} et de colonnes COL₁, COL_{M} de cellules C₁₁,...,C_{NM}SRAM.

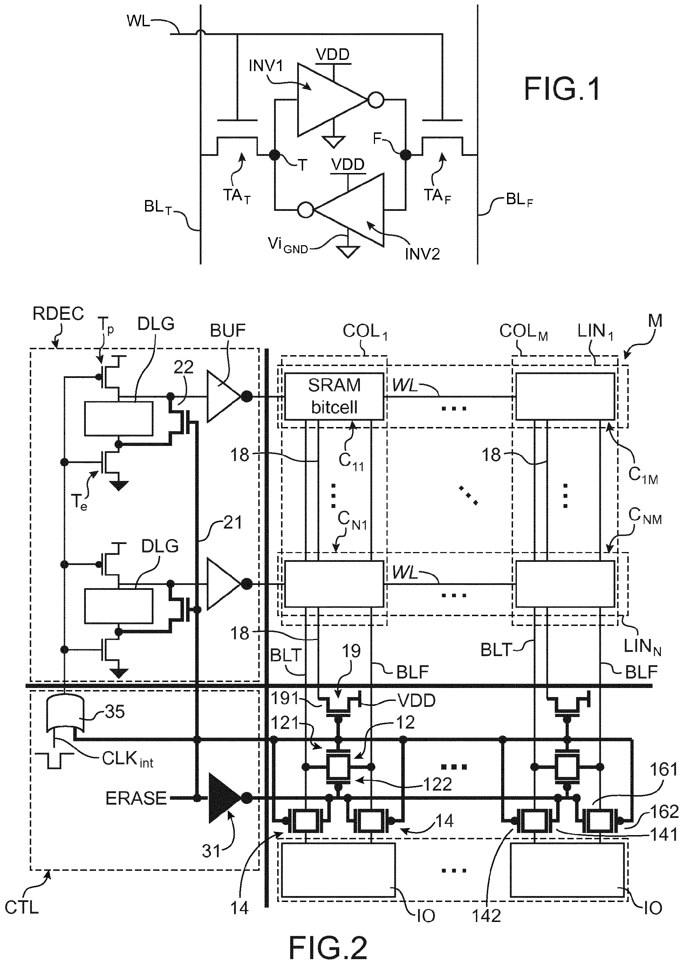

Les cellules peuvent avoir un agencement conventionnel et tel qu'illustré sur la figure 1. Le circuit d'effacement rapide peut être ainsi implémenté sans modification de la structure interne des cellules SRAM et ne requiert la mise en oeuvre que d'un nombre restreints d'éléments additionnels périphériques au plan mémoire. On estime l'encombrement supplémentaire que ces éléments additionnels sont susceptibles d'engendrer typiquement inférieur à 5% par rapport à un dispositif conventionnel équivalent.

Sur la figure 1, la cellule SRAM représentée est ainsi dotée de deux noeuds de stockage T et F, prévus pour conserver une première information logique, et une information logique complémentaire de la première information. Le maintien des informations logiques dans les noeuds est assuré par des transistors formant des inverseurs INV1, INV2 bouclés sur eux-mêmes. Par exemple, lorsque la cellule SRAM est de type communément appelé « 6T » et formée ainsi de 6 transistors, les deux inverseurs INV1, INV2, sont typiquement réalisés par deux transistors de charge et deux transistors de conduction. Les inverseurs INV1, INV2 sont dans cet exemple alimentés par un potentiel d'alimentation VDD. La cellule est également connectée à une ligne virtuelle d'alimentation basse, ici une ligne de masse virtuelle VirGND, elle-même reliée à une ligne de masse

L'accès aux noeuds de stockage T et F est réalisé par le biais de deux transistors d'accès TA_{T} et TA_{F} connectés respectivement à des lignes dites de bit BL_{T} et BL_{F} généralement partagées par les cellules SRAM d'une même colonne de cellules du plan matriciel.

L'accès aux noeuds de stockage T et F est commandé par une ligne de mot WL généralement partagée par des ou les cellules SRAM d'une même ligne de cellules du plan matriciel. Les transistors d'accès TA_{T} et TA_{F} sont ainsi prévus pour permettre l'accès ou bloquer l'accès respectivement au premier noeud T et au deuxième noeud F.

Pour permettre d'effectuer un effacement rapide d'information logique stockée dans une telle cellule, on prévoit un circuit d'effacement disposé en périphérie du plan matriciel et commandé par un signal d'effacement ERASE.

Le signal d'effacement ERASE peut être un signal logique dont un changement d'état est déclenché par exemple par une détection d'une tentative frauduleuse d'accès à une information stockée dans la SRAM. La manière dont cette détection est réalisée n'est pas l'objet de la présente demande. Le processus d'effacement mis en oeuvre est indépendant du mode (lecture, écriture, ou rétention) de fonctionnement dans laquelle la mémoire se situe et peut être effectué sans mise hors tension d'éléments périphériques à la matrice de cellules mémoires.

L'effacement d'une cellule est ici réalisé en activant ses transistors transistors d'accès, autrement dit en les rendant passant, et en mettant notamment en court-circuit les lignes de bit BL_{T} et BL_{F}, de sorte à amener les lignes de bit BL_{T} et BL_{F} vers un même potentiel.

On ne distingue alors plus les niveaux logiques respectifs des noeuds de stockage T et F, ce qui constitue un effacement de l'information stockée dans la cellule. Les lignes de bit BL_{T} et BL_{F} étant partagées par des cellules voire toutes les cellules d'une même colonne donnée de l'agencement matriciel, la mise en connexion des lignes de bit BL_{T} et BL_{F} permet l'évacuation des charges contenues dans les noeuds de stockage de toutes les cellules de cette colonne donnée. On peut effectuer ainsi effectuer un effacement simultané des cellules d'une colonne entière de cellules SRAM. Dans ce cas, on sélectionne toutes les cellules de cette colonne en activant ou rendant passant leurs transistors d'accès respectifs.

Plutôt qu'une écriture simultanée d'informations de remplacement dans les cellules, la solution d'effacement suivant l'invention rend encore plus difficile une éventuelle remontée à l'information stockée. De plus, pour mettre en oeuvre un effacement par écriture simultanée d'une information de remplacement, la grille d'alimentation devrait alors être renforcée afin de s'assurer qu'un fort appel en courant ainsi engendré permettre d'écrire correctement cette information dans l'ensemble de la mémoire. Un tel renforcement de la grille d'alimentation pourrait alors se traduire par une perte de surface supplémentaire non négligeable.

On réalise la mise en court-circuit des lignes de bits BL_{T} et BL_{F} par le biais d'un élément commutateur, typiquement ajouté en pied de colonne, commandé par le signal d'effacement ERASE.

Dans l'exemple de réalisation illustré sur la figure 2, l'élément commutateur 12 est sous forme d'une porte de passage (« pass-gate » ou « transmission-gate » selon la terminologie anglo-saxonne). Une telle porte de passage 12 est composée d'un transistor 121 de type N et d'un transistor 122 de type P ayant leurs drain et source respectives connectées ensemble. Les transistors 121 et 122 ont leurs électrodes de grilles respectives commandées respectivement par le signal d'effacement ERASE et un signal complémentaire (inverse) de ce signal ERASE.

Une telle porte de passage 12 permet ainsi, en fonction de l'état du signal d'effacement ERASE, alternativement de connecter ensemble les lignes de bit BL_{T} et BL_{F} lorsqu'on souhaite réaliser un effacement, ou de déconnecter l'une de l'autre les lignes de bit BL_{T} et BL_{F} en fonctionnement normal du plan mémoire, c'est-à-dire lors de ses différents modes de lecture, d'écriture, et de rétention.

On peut prévoir de réaliser l'effacement de plusieurs colonnes de cellules SRAM. Dans l'exemple de réalisation illustré, une porte de passage 12 est donc prévue au pied de chacune des colonnes de cellules. On peut ainsi mettre en court-circuit toutes les paires de lignes de bits BL_{T} et BL_{F} associées respectivement aux colonnes du plan matriciel et effectuer un effacement simultané par le biais du signal ERASE.

Le circuit d'effacement rapide est avantageusement configuré en outre pour que, lorsque les lignes de bits BL_{T} et BL_{F} sont mises en court-circuit, ces lignes de bits BL_{T} et BL_{F}, soient isolées d'un élément de circuit IO périphérique au plan mémoire et situé à une extrémité de la colonne de cellules, généralement en pied de colonne. Cet élément de circuit IO périphérique comprend typiquement un amplificateur de lecture (SA pour « sense amplifier » selon la terminologie anglo-saxonne) et/ou un circuit de pilotage d'opérations écriture (WR driver).

Lors de l'effacement, on déconnecte ainsi avantageusement les lignes de bits BL_{T} et BL_{F} d'éléments susceptibles d'être alimentés. Cela participe à une évacuation rapide des charges dans les cellules tout en préservant le circuit périphérique des conséquences néfastes de cette évacuation de charges. Outre l'amplificateur de lecture, et le circuit de pilotage d'opérations écriture, les lignes de bits peuvent être déconnectées d'un circuit de pré-charge. On isole ainsi les lignes de bits BL_{T} et BL_{F} d'éléments susceptibles d'imposer un potentiel et de ralentir la mise au même potentiel des lignes de bits.

Des éléments commutateurs 14 et 16 supplémentaires sont ainsi prévus pour assurer cet isolement des lignes de bits BL_{T} et BL_{F}. Dans l'exemple illustré, ces autres éléments commutateurs 14 et 16 sont sous forme respectivement de portes de passage 14, 16 (« pass-gate » ou « transmission-gate »). Une porte de passage 14 située entre une première ligne de bit BL_{T} et un élément de circuit périphérique IO comportant un amplificateur de lecture et un circuit de pilotage d'opérations d'écriture. La porte de passage 14 est composée typiquement d'un transistor 142 de type P et d'un transistor 141 de type N dont les grilles sont commandées respectivement par le signal d'effacement ERASE et son complémentaire.

Une telle porte de passage 14 permet ainsi, en fonction de l'état du signal d'effacement ERASE, alternativement d'isoler la première ligne BLT lorsqu'on souhaite réaliser un effacement, ou de connecter cette ligne de bit BLT à l'élément de circuit périphérique IO en fonctionnement normal du plan mémoire.

La porte de passage 16 située entre la deuxième ligne de bit BLF et l'élément de circuit périphérique IO, est composée typiquement d'un transistor 162 de type P et d'un transistor 161 de type N dont les grilles sont commandées respectivement par le signal d'effacement ERASE et le signal complémentaire (inverse) de ce signal.

En fonctionnement normal du plan mémoire, les cellules sont alimentées par un circuit d'alimentation, typiquement sous forme d'une grille, apte à délivrer un potentiel d'alimentation, dans cet exemple égal à VDD, à une ligne d'alimentation 18 partagée par une pluralité de cellules C₁₁,...C_{N1}. Le potentiel d'alimentation VDD sert notamment à polariser les transistors des inverseurs INV1, INV2 des cellules C₁₁,...C_{N1}. La ligne d'alimentation 18 est également appelée ligne d'alimentation virtuelle et peut être amenée à être déconnectée de la grille d'alimentation lors d'un effacement. Le circuit d'effacement permet de déclencher une déconnection ou de mis en haute impédance ou de laisser flottante la ligne d'alimentation 18.

Pour faciliter l'évacuation rapide de charges électriques et par conséquent permettre un effacement rapide de la mémoire tout en limitant la consommation, on prévoit, selon un mode de réalisation particulièrement avantageux, en outre, dès le déclenchement de l'opération d'effacement, de déconnecter provisoirement le plan (matrice) mémoire de son circuit d'alimentation.

Dans l'exemple de réalisation particulier illustré sur la figure 2, la ligne d'alimentation 18 prévue pour appliquer un potentiel d'alimentation VDD est partagée par les cellules C₁₁,...C_{N1} d'une même colonne COL₁ de cellules. Lors du processus d'effacement la ligne d'alimentation 18 est déconnectée ou mise en haute impédance ou laissée flottante la ligne d'alimentation 18 et le potentiel d'alimentation VDD n'est plus appliqué aux cellules C₁₁,...C_{N1} de la colonne COL₁ de cellules.

Le circuit d'effacement est avantageusement doté en outre d'un élément interrupteur 19 commandé par le signal d'effacement ERASE et configuré pour, consécutivement à une réception du signal d'effacement ERASE, déconnecter ladite ligne d'alimentation 18 dudit circuit (ou grille) d'alimentation.

L'élément interrupteur 19 peut être sous forme d'un transistor 191, dans l'exemple illustré de type PMOS, qui est disposé entre le circuit d'alimentation à une tension VDD et la ligne d'alimentation 18 et dont la grille est susceptible de recevoir le signal d'effacement ERASE. Dans l'exemple particulier illustré, le transistor 191 interrupteur est situé en pied de colonne, avec une grille connectée aux différents éléments commutateurs 12, 14, 16 décrits précédemment.

Selon une variante d'agencement (non représentée), on peut également prévoir qu'une ligne de polarisation apte à acheminer le potentiel d'alimentation VDD et partagée par des cellules d'une même ligne (rangée horizontale) LINk de cellules. Dans ce cas, on prévoit un agencement différent de l'élément interrupteur 19, ce dernier pouvant être disposé à une extrémité de cette ligne LINk, entre cette ligne et le circuit d'alimentation.

Pour permettre de réaliser un effacement simultané de plusieurs lignes de cellules et de préférence de toutes les cellules du plan matriciel, le circuit d'effacement est avantageusement doté en outre de moyens de sélection simultanée de lignes de cellules, commandés par le signal d'effacement ERASE, et configurés pour effectuer une sélection simultanée de plusieurs lignes de cellules et de préférence de toutes les cellules du plan matriciel. Ces moyens de sélection sont intégrés à un décodeur de ligne RDEC du plan mémoire et sont adaptés pour effectuer une activation simultanée des différentes lignes de mots WL associées à différentes lignes LIN₁,..., LIN_{N}(rangées horizontales) de cellules, et permettre ainsi d'accéder aux cellules commandées par ces différentes lignes de mot.

Dans l'exemple de réalisation illustré sur la figure 2, pour mettre en oeuvre une activation simultanée de toutes les lignes de mots WL, on ajoute au décodeur de ligne RDEC associé au plan mémoire, une ligne 21 prévue pour acheminer le signal d'effacement ERASE. Le décodeur RDEC est typiquement un décodeur 1 parmi N avec N le nombre de lignes du plan mémoire. A chaque étage du décodeur de ligne RDEC associé une ligne de cellules de la matrice, on ajoute en outre un transistor 22, dont la grille est connecté à la ligne 21. Ce transistor 22 est ainsi prévu pour connecter la ligne 21 à cet étage lorsque le signal d'effacement ERASE est reçu par la ligne 21. Le transistor 22, dont la grille est commandée par le signal d'effacement ERASE, est connecté à une porte logique DLG d'un étage du décodeur et à l'entrée d'un circuit tampon BUF (« buffer » selon la terminologie anglo-saxonne) situé en sortie du décodeur de ligne RDEC. Le circuit tampon BUF est typiquement formé d'au moins un inverseur ou d'une succession d'inverseurs en série. Les portes logiques DLG sont dans cet exemple implémentées en logique dynamique.

Elles peuvent être ainsi dotées chacune d'un transistor de précharge Tp et d'un transistor d'évaluation Te commandés par un signal de cadencement. Le transistor 22 comporte un drain connecté au transistor de précharge Tp de la porte dynamique et comporte une source connectée au transistor d'évaluation.

Le signal d'effacement ERASE et son complémentaire, peuvent être délivrés par un contrôleur CTL, c'est-à-dire un circuit logique périphérique de contrôle de la mémoire, qui suivant une suite d'états, est configuré notamment pour gérer les processus de lecture et d'écriture. Le contrôleur CTL peut avoir une structure conventionnelle à laquelle on peut notamment prévoir en outre d'ajouter des moyens supplémentaires ou un circuit pour recevoir le signal d'effacement ERASE et pour appliquer ce signal ERASE et son complémentaire respectivement à l'élément commutateur 12 chargé de la mise en court-circuit des lignes de bits BLT et BLF, aux éléments commutateurs 14, 16 dédiés à l'isolement des bits lorsqu'elles sont mises en court-circuit, à l'élément interrupteur 19 prévu pour isoler les cellules de leur circuit d'alimentation. Ces moyens supplémentaires peuvent comprendre un inverseur 31.

Le contrôleur CTL est également doté de moyens 35 pour fournir le signal de cadencement aux décodeurs de ligne et réalisant un OU logique entre le signal d'effacement ERASE et un signal d'horloge interne CLKint généré en interne par le contrôleur. Le signal CLKint est typiquement sous forme d'impulsion dont la durée régit celle du mode (lecture ou écriture) dans laquelle se trouve une cellule sélectionnée.

Lorsque c'est le signal ERASE qui est émis, ce sont toutes les lignes de mots WL de la matrice qui sont activées de manière simultanée quelque que soit leur état précédent cette opération.

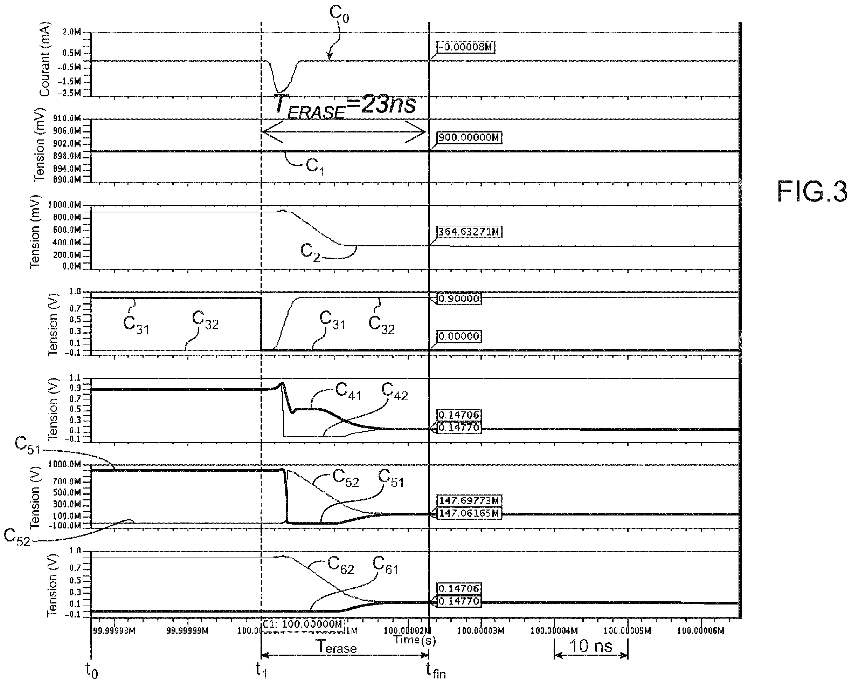

La Figure 3 donne un exemple de chronogramme de simulation représentatif d'un processus d'effacement mis en oeuvre par un circuit d'effacement rapide du type de celui décrit précédemment, avec une tension d'alimentation VDD de l'ordre de 0.9 V, des cellules de type SS (pour « Slow » - « Slow ») formées de transistors NMOS et PMOS de type à commutation dite « lente », des lignes de bits ayant une capacité sensiblement égale à celle de la ligne d'alimentation 18 à Vdd, et une température de fonctionnement établie à -40°C. Dans cet exemple, les colonnes de cellules comportent 512 cellules avec 511 cellules stockant une information logique '1' et une cellule stockant une information logique '0'. La simulation est donc effectuée dans des conditions de température, de potentiel de polarisation, de rapidité des transistors, et de nature des informations logiques stockées particulièrement défavorables à un effacement rapide. Le temps d'effacement obtenu dans cet exemple peut être cependant de l'ordre de plusieurs dizaines de nano-secondes par exemple de l'ordre de 20 ns.

Sur le chronogramme, les courbes C0 et C2 sont représentatives respectivement d'un courant pris sur la ligne 18 d'alimentation et du potentiel d'alimentation délivré par cette ligne 18 aux cellules d'une colonne, tandis que la courbe C1 est représentative de la tension VDD délivrée par le circuit d'alimentation.

Les courbes C31 et C32 sont représentatives respectivement du signal pris en entrée de l'inverseur BUF et en sortie de cet inverseur et donc du décodeur de lignes RDEC.

Les courbes C41 et C42 sont représentatives respectivement du signal pris sur les lignes de bits BLT et BLF, la ligne de bit BLF étant pré-chargée dans cet exemple à VDD.

Les courbes C51 et C52 sont représentatives respectivement de signaux pris respectivement sur le premier noeud T et le second noeud F d'une cellule dans laquelle une information logique '0' a été écrite tandis que les autres cellules de la même colonne sont mise à '1'.

Les courbes C61 et C62 sont représentatives respectivement de signaux pris respectivement sur le premier noeud T et le second noeud F d'une cellule dans laquelle une information logique '1' a été stockée.

Avant effacement, entre t0 et t1, le circuit d'alimentation est connecté à la ligne d'alimentation 18 qui délivre aux cellules le potentiel VDD. Les lignes de mots sont désactivées, tandis que les lignes de bits BLT et BLF sont préchargées au potentiel VDD.

L'opération d'effacement débute à un instant t1, à partir duquel toutes les cellules sont sélectionnées par activation des lignes de mots (courbe C41), les lignes de bits BLT et BLF sont mises en court-circuit et la ligne d'alimentation au potentiel VDD est tout simplement déconnectée du circuit d'alimentation ou grille d'alimentation de la mémoire.

On considère comme temps d'effacement la durée entre un instant t1 et un instant tfin pour que la dernière des 512 cellules ait ses noeuds de stockage au même potentiel.

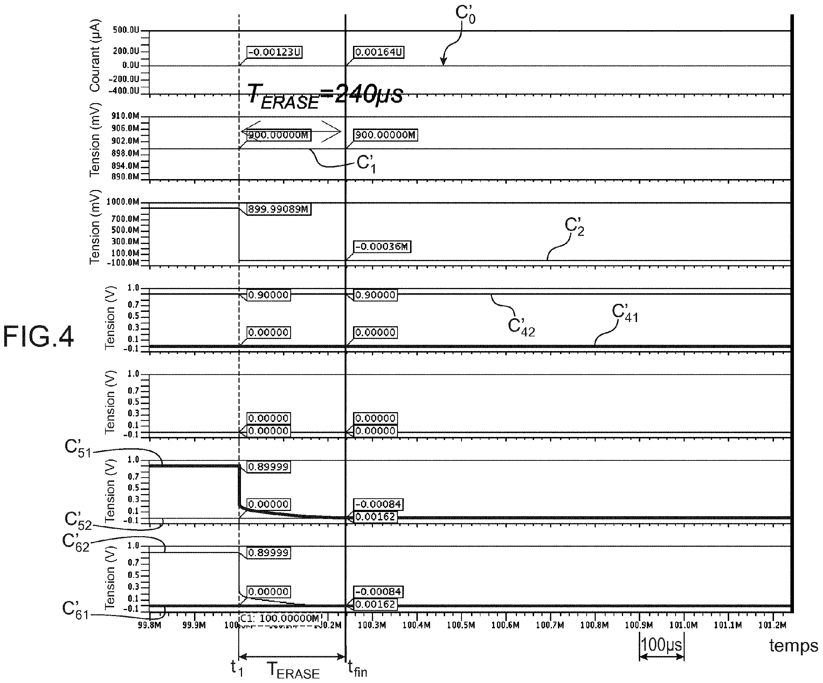

A titre de comparaison, la figure 4 donne un chronogramme d'enchainement des phases d'une opération d'effacement mise en oeuvre sur des cellules identiques et prises dans les mêmes conditions (température, alimentation, rapidité des transistors,...) que celles décrites en liaison avec la figure 3, mais avec un procédé d'effacement différent.

Cette fois, la simulation d'opération d'effacement est réalisée sans activation simultanée des lignes de mots WL et en mettant simplement l'alimentation à la masse. La mise à la masse simulée dans cet exemple est effectuée de manière quasi instantanée pour se mettre dans le cas le plus favorable de ce mode d'effacement. Les courbes C'0, C'1, C'2, C'31,C'32, C'41, C'42, C'51, C'52, C'61, C'62 sont représentatives des même types de signaux que les courbes C0, C1, C2, C31,C32, C41,C42, C51, C52, C61, C62 données sur la figure 3.

Ainsi, on constate que dans des conditions de fonctionnement similaires à celles données précédemment en lien avec la figure 3, le temps requis pour que l'information contenue dans une cellule (mise dans les mêmes conditions que celle déterminant la fin du processus d'effacement) soit totalement perdue ou effacée, est de l'ordre de plusieurs centaines microsecondes, par exemple de l'ordre de 200 µs. La durée d'effacement est donc bien supérieure.

L'activation de chaque cellule et la mise en court-circuit des lignes de bits telle que mise en oeuvre par le circuit d'effacement décrit précédemment permet ainsi d'évacuer les charges électriques de manière plus efficace et plus rapide qu'une simple mise à la masse de la ligne d'alimentation 18.

Un bloc 200 du circuit d'effacement recevant en entrée IN le signal d'effacement ERASE décrit plus haut, peut être prévu pour délivrer en sortie OUT un signal de détection de fin d'opération d'effacement ERASE_END marquant la fin de l'opération d'effacement décrite précédemment. Un tel signal de fin d'opération d'effacement ERASE_END permet de s'assurer que l'opération d'effacement a bien été réalisée. Un tel signal peut être en particulier utile pour permettre de déterminer lorsque la mémoire est prête pour un nouveau cycle, et pour pouvoir ainsi la réutiliser plus rapidement. Un tel signal trouve une utilité toute particulière lorsque la mémoire comporte une alimentation VDD modulable. En effet, un changement de la tension d'alimentation appliquée aux cellules peut induire une durée d'effacement variable. Il est donc particulièrement avantageux dans ce cas de disposer d'un moyen de détection de fin d'effacement.

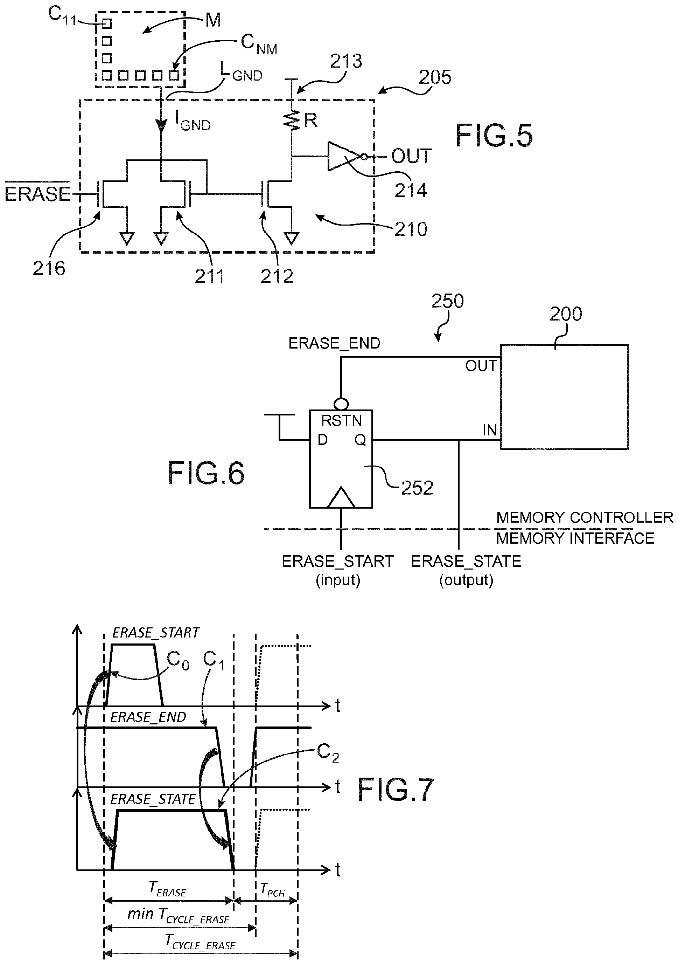

Dans l'exemple de réalisation illustré sur la figure 5, un étage 205 du bloc 200 utilise un courant I_{LGND} issu de la ligne d'alimentation basse, en particulier la ligne de masse L_{GND} de la matrice M de cellules C₁₁,..., C_{NM}, pour produire le signal de fin d'effacement ERASE_END lorsque le courant I_{LGND} issu de cette ligne d'alimentation basse passe en dessous d'un seuil.

Comme indiqué plus haut, lors de l'opération d'effacement commandée par une mise dans un état donné du signal ERASE, la matrice M est déconnectée de son alimentation. Cette déconnexion provoquant une décharge des cellules et un courant I_{LGND} généré au niveau d'une ligne de masse L_{GND} reliée aux cellules est produit. Une détection du passage du courant I_{LGND} en dessous d'un seuil peut être réalisée par exemple par le biais d'un amplificateur 210 de détection en courant, muni de transistors 211, 212 formant un miroir de courant. Un moyen 213 formant une résistance R de détection de courant permet de convertir le courant I_{GND} dans la ligne d'alimentation basse en une tension, qui est délivrée en entrée d'un inverseur 214 dont la sortie OUT déclenche, par le biais d'un changement d'état, la production d'un signal de fin d'effacement ERASE_END.

La production de ce signal de fin d'effacement ERASE_END permet de déclencher un changement d'état du signal ERASE émis en entrée IN du bloc 200 du circuit d'effacement et qui permet de commander le décodeur de lignes RDEC ainsi que les éléments commutateurs 12, 14, 16 et l'interrupteur 19.

Pour permettre ce changement d'état, on peut prévoir comme sur la figure 6, un étage 250 de commande d'état du signal d'effacement ERASE muni d'une bascule D 252, dont l'entrée D est forcée dans cet exemple à un niveau '1' et dont l'état de la sortie détermine celui du signal d'effacement ERASE.

Comme cela est illustré sur le chronogramme de la figure 7, un front (dans cet exemple un front montant sur la courbe C₀), d'un signal de déclenchement d'effacement ERASE_START provenant de l'interface d'entrée sortie ou d'un contrôleur de la mémoire permet de déclencher un premier changement d'état du signal d'effacement ERASE. Ce changement d'état permet de commander les différents éléments, en particulier le décodeur de ligne R_DEC, l'élément commutateur 12, l'élément commutateur 14, l'élément interrupteur 19 qui participent à l'opération d'effacement.

Ce n'est que lorsque le signal appliqué sur l'entrée asynchrone reset de la bascule 252 et qui provient de la sortie OUT du bloc 200 produisant le signal de détection de fin d'effacement ne change d'état (front descendant sur la courbe Ci) que le signal d'effacement ERASE peut lui même à nouveau changer d'état (front descendant sur la courbe C₂) ce qui conduit notamment à un arrêt de la sélection simultanée d'un ensemble de lignes de cellules, à une déconnexion l'une de l'autre des lignes de bit BL_{T} et BL_{F}.

Sur ce chronogramme Tₑᵣₐₛₑ représente la durée de l'opération d'effacement et T_{PCH} celle nécessaire à une pré-charge des lignes de bits une fois qu'elles ont été déconnectées l'une de l'autre et qui est réalisée afin de préparer le dispositif à un nouveau cycle de fonctionnement.

## Revendications

1. Dispositif de mémoire statique à accès aléatoire comprenant une matrice mémoire dotée d'au moins une colonne (COL₁) formée d'une pluralité de cellules (C₁₁, C_{N1}) mémoires SRAM chacune desdites cellules comprenant :
- un premier noeud (T) de stockage d'information logique et un deuxième noeud de stockage (F) d'information logique complémentaire,
- un premier transistors d'accès (TA_{T}) au premier noeud de stockage et un deuxième transistor d'accès (TA_{F}) au deuxième noeud de stockage, le premier transistor d'accès et le deuxième transistor d'accès étant respectivement connectés à une première ligne de bit (BL_{T}) et à une deuxième ligne (BL_{F}), la première ligne de bit et la deuxième ligne de bit étant partagée par lesdites cellules de ladite colonne,
le dispositif étant doté en outre d'un circuit d'effacement de la mémoire configuré pour consécutivement à une réception d'un signal d'effacement (ERASE), rendre passant les transistors d'accès desdites cellules et connecter entre elles la première ligne de bit (BL_{T}) et la deuxième ligne de bit (BL_{F}).

2. Dispositif selon la revendication 1, le circuit d'effacement étant doté d'au moins un premier élément commutateur (12), en particulier une première porte de passage, configuré pour alternativement connecter entre elles et déconnecter l'une de l'autre la première ligne de bit (BL_{T}) et la deuxième ligne de bit (BL_{F}), l'élément commutateur (12) étant commandé par le signal d'effacement (ERASE) et étant agencé entre une extrémité de ladite colonne (COL₁) de cellule et une portion d'un circuit périphérique (IO) à ladite matrice, ledit circuit périphérique étant doté d'un amplificateur de lecture (SA) et/ou d'un pilote d'opérations de lecture et/ou d'écriture.

3. Dispositif selon la revendication 2, le circuit d'effacement étant doté en outre d'autres éléments commutateurs (14, 16), en particulier d'une deuxième porte de passage (14) et d'une troisième porte de passage (16), commandés par le signal d'effacement (ERASE), et configurés pour, consécutivement à une réception du signal d'effacement, déconnecter respectivement la première ligne de bit (BL_{T}) et la deuxième ligne de bit (BL_{F}) de ladite portion de circuit périphérique (IO).

4. Dispositif selon l'une des revendications 1 à 3, comprenant une ou plusieurs lignes d'alimentation (18) pour fournir un potentiel d'alimentation (VDD) à ladite pluralité de cellules (C₁₁, C_{N1}) mémoires SRAM, ledit circuit d'effacement étant configuré pour, consécutivement à la réception du signal d'effacement, laisser flottantes ou mettre en haute impédance lesdites une ou plusieurs lignes d'alimentation (18).

5. Dispositif selon l'une des revendications 1 à 4, dans lequel la matrice mémoire est alimentée par un circuit d'alimentation apte à délivrer un potentiel d'alimentation (VDD) à au moins une ligne d'alimentation (18) partagée par une pluralité de cellules données, ledit circuit d'effacement étant doté en outre d'un élément interrupteur (19) commandé par le signal d'effacement (ERASE) et configuré pour, consécutivement à une réception d'un signal d'effacement, déconnecter ladite ligne d'alimentation (18) dudit circuit d'alimentation.

6. Dispositif selon la revendication 5, ladite pluralité de cellules données appartenant à la dite colonne (COL1).

7. Dispositif selon l'une des revendications 1 à 6, dans lequel la matrice mémoire est associée à un contrôleur périphérique (CTL) pour la gestion de processus de lecture et d'écriture, le circuit d'effacement comprenant en outre des moyens ou un élément de circuit intégré(s) audit contrôleur (CTL) et dotés d'un inverseur (31), les moyens ou l'élément de circuit intégré(s) étant configurés pour appliquer le signal d'effacement et un signal complémentaire dudit signal d'effacement.

8. Dispositif selon l'une des revendications 1 à 7, dans lequel la matrice est agencée en outre en rangées (LIN₁,...,LIN_{N}) d'une ou plusieurs cellules SRAM et dans lequel une pluralité de ligne de mot (WL) sont connectées respectivement à ladite pluralité de cellules mémoires SRAM de la dite colonne (COL₁), chaque ligne mot permettant lorsqu'elle est activée de sélectionner la ou les cellules mémoires d'une rangée donnée de cellules SRAM parmi lesdites rangées de cellules SRAM, le circuit d'effacement comprenant en outre des moyens d'activation (21, 22) simultanée desdites lignes de mots pour effectuer une activation simultanée des lignes de mot de manière à effectuer une sélection simultanée desdites rangées de cellules SRAM.

9. Dispositif selon la revendication 8, dans lequel les moyens d'activation de ligne de mots comportent une pluralité de transistors (22) disposés respectivement à différents étages d'un décodeur de lignes (RDEC), lesdits transistors (22) ayant une électrode de grille commandée par le signal d'effacement (ERASE).

10. Dispositif selon la revendication 9, dans lequel le décodeur de lignes (RDEC) est doté de portes logiques dynamiques (DLG) et dans lequel la matrice mémoire est associée à un contrôleur périphérique (CTL) pour la gestion de processus de lecture et d'écriture, le circuit d'effacement comprenant des moyens pour délivrer un signal de cadencement des portes logiques dynamiques et formant un OU logique entre un signal d'horloge interne au décodeur de lignes et le signal d'effacement ERASE.

11. Dispositif selon l'une des revendications 1 à 10, dans lequel le circuit d'effacement est doté d'un étage de détection (205) de fin d'effacement pour produire un signal de fin d'effacement (ERASE_END) indiquant la fin d'une opération d'effacement réalisée par ledit circuit d'effacement.

12. Dispositif selon la revendication 11, dans lequel l'étage de détection de fin d'effacement est configuré de sorte à :
- détecter, lorsqu'un courant (I_{LGND}) issu d'une ligne d'alimentation basse reliées auxdites cellules de la matrice, passe en dessous d'un seuil et, consécutivement à ce passage :
- générer le signal de fin d'effacement (ERASE_END).

13. Dispositif selon la revendication 12, dans le circuit d'effacement comprend en outre un étage (250) de commande d'état du signal d'effacement pour, consécutivement à une réception dudit signal de fin d'effacement (ERASE_END), modifier l'état dudit signal d'effacement (ERASE).
